# EUROPEAN PATENT SPECIFICATION

(11) **EP 0 439 128 B1**
(45) Date of publication and mention of the grant of the patent: **17.04.1996**
(21) Application number: 91100780.5
(22) Date of filing: 22.01.1991
(51) Int. Cl.: H01L 23/06, H01L 23/373

(54) **Housing for semiconductor device and method of manufacturing**
Gehäuse für eine Halbleitervorrichtung und Herstellungsverfahren dafür
Boîtier pour dispositif semi-conducteur et procédé de fabrication

(30) Priority: 22.01.1990 JP 13091/90
(43) Date of publication of application: 31.07.1991
(73) Proprietor: SUMITOMO ELECTRIC INDUSTRIES, LTD., Osaka-shi, Osaka 541 (JP)
(72) Inventor: Osada, Mitsuo, c/o Itami Works of Sumitomo El., Itami-shi, Hyogo (JP); Abe, Yugaku, c/o Itami Works of Sumitomo El., Itami-shi, Hyogo (JP); Hayashi, Tetsuya, c/o Itami Works of Sumitomo El., Itami-shi, Hyogo (JP)
(74) Representative: Herrmann-Trentepohl, Werner, Dipl.-Ing.

(56) References cited:
- US-A- 4 402 905
- US-A- 4 702 885
- US-A- 4 703 339
- US-A- 4 830 820

## Description

### Field of the Invention

The present invention relates generally to housings for semiconductor devices, and more particularly, to housings for semiconductor devices which are improved not to be distorted due to heating. The present invention further relates to a method of manufacturing such a housing for a semiconductor device.

### Description of the Related Art

There is an increasing demand for a lightweight electronic devices mounted on flying bodies such as aircrafts, artificial satellites and missiles. In recent years in particular, with the increased kinds and numbers of electronic apparatuses mounted on each of such flying bodies, the requirements on lightweight housings for housing electronic parts incorporated in electronic apparatuses become more demanding.

Aluminum has been conventionally used as a material for a housing. Aluminum is light in weight (specific gravity is about 2.7g/cc) but large in a thermal expansion coefficient (24 x 10⁻⁶/°C). Therefore, in connecting a ceramic substrate (having a thermal expansion coefficient of 6-7 x 10⁻⁶/°C) with electronic parts mounted thereon to a housing by soldering (lead tin, gold tin or the like), the difference between the thermal expansion coefficients of the substrate and that of the housing is so large that a warping in a junction portion and a crack in the ceramic substrate are produced.

In addition, the increased number of ceramic substrates have been recently used which mount FETs or ICs of large heat radiation thereon. In this case, the ceramic substrate is fixed to a housing by soldering or the like and the housing is cooled, thereby causing the generated heat to externally escape through the cooled housing. In such a case, since aluminum having a large thermal expansion coefficient cannot be used as a material for the housing, such materials as Fe-Ni-Co (10 - 11g/cc, a thermal conductivity of 0.03 cal/cm·sec.°C) and the like are used, sacrificing lightness and a thermal conductivity characteristic.

The technique is known which uses an Aℓ-Si compound material manufactured by a rapid solidification method as a material for a substrate on which a semiconductor device is mounted and as a material for a heat radiation fin (USP 4,830,820, USP 4,926,242). The Aℓ-Si compound material (35 - 40% by weight of Si : 65 - 55% by weight of Aℓ) manufactured by the quenching method has the specific gravity (about 2.5 g/cc) smaller than that of aluminum and a relatively high thermal conductivity (0.3 cal/cm·sec·°C) and it is therefore considered to be suitable for use as a material for a housing.

A housing formed of this Aℓ-Si compound material is prepared by processing through hot working and cutting, alloy powder obtained by rapid solidification melted Aℓ (60% by weight) and Si (40% by weight) through an atomizing method.

However, this Aℓ-Si compound material has the following disadvantages when applied to a housing.

First is distortion produced when in processing a housing. That is, since a housing of this kind in general should be cooled when used, the housing must be attached to a cooling device. The deformation of the rear of the housing should be accordingly minimized by correcting the same by a heat treatment. Heating the housing obtained by such methods as described above, that is, obtained by cutting a material made of quenched powder formed by hot working, causes the housing to be greatly distorted due to an occlusion gas (N₂, H₂, H₂O etc.) included in the material. In this case, even if the heating is carried out in a vacuum or in an inactive gas such as argon, the above-described distortion is produced due to the emission of the occlusion gas. This is the first disadvantage.

Second is thermal distortion after plating. In many cases, a surface of a housing should be plated with Ni, Ni + Au or the like to make the housing easy to be soldered and to give the same good anti-corrosiveness. The heating after plating results in emission of an occlusion gas which causes distortion of the housing. The heating after soldering the ceramic substrate or the like to the housing also results in emission of an occlusion gas, thereby distorting the housing. In this case, the plated layer is expanded. The foregoing is the second disadvantage.

Third is that welding a cover made of an aluminum alloy to the housing by using laser produces bubbles at the welded portion and makes Si particles coarse. Both of such phenomena significantly deteriorates airtightness and reliability in hardness after the welding of the cover to the housing. While the bubbles are mainly caused by the emission of the occlusion gas as described in the first disadvantage at the time of fusing a welded portion, they are also caused by coarse Si particles which will be described in the following. That is, the Aℓ-Si compound material formed by the quenching method is characterized by the dispersed fine particle Si into Aℓ through rapid solidification and that when the melted portion at the time of welding is slowly cooled, the Si particles are made coarse when being solidified, thereby producing cavities in the Aℓ in the periphery of the Si particles, which makes the welded portion fragile. US-A-4 830 820 discloses a method for producing an Aℓ-Si material.

### SUMMARY OF THE INVENTION

An object of the present invention is to provide a housing for a semiconductor device having a small thermal expansion coefficient and enhanced thermal conductivity.

Another object of the present invention is to provide a housing for a semiconductor device improved to avoid distortion when heat is applied.

A further object of the present invention is to provide a housing for a semiconductor device in which no occlusion gas is emitted at the time of heating.

A further object of the present invention is to provide a housing for a semiconductor device having improved airtightness and reliability in hardness after jointing a housing member and a cover.

A further object of the present invention is to provide a housing for a semiconductor device in which a connection portion between a housing member and a cover is not made fragile.

A further object of the present invention is to provide a manufacturing method of a housing for a semiconductor device which is not distorted when heat is applied.

A further object of the present invention is to provide a manufacturing method of a housing for a semiconductor device requiring no process for correcting warping.

A further object of the present invention is to provide a manufacturing method of a housing for a semiconductor device which is formed of an Aℓ-Si compound material and having a cover attaching portion formed of an aluminum alloy layer.

In order to attain the above-described objects, the housing for a semiconductor device according to the present invention includes a housing member formed of an Aℓ-Si compound material and having a space for enclosing said semiconductor device. Said Al-Si compound material contains an occlusion gas in which a nitrogen gas is 0.01 percentage by weight or less.

In accordance with another aspect of the present invention, in a manufacturing method of a housing for a semiconductor device, an Aℓ-Si rapidly solidified powder is prepared. The Aℓ-Si rapidly solidified powder is formed by hot working into an Aℓ-Si compound material. The Aℓ-Si compound material is placed in the vacuum of 0.13 Pa (10⁻³ torr) or below at a temperature of 300 - 500°C to remove an occlusion gas included in the Aℓ-Si compound material. The Aℓ-Si compound material is processed by cutting to form a housing member.

The heating temperature is limited to 300 - 500°C because that of below 300°C produces less effect. The upper limit is settled to 500°C taking into consideration that an eutectic point between Si and Aℓ is at 570°C.

According to a further aspect of the present invention, in a manufacturing method of a housing for a semiconductor device, an Aℓ-Si rapidly solidified powder is first prepared. The Aℓ-Si rapidly solidified powder is molded by static pressure and the molding thereof is put in a sheath tube made of an Aℓ alloy. The sheath tube and the Aℓ-Si compound molding are extrusion-molded as an unit to form a material with an Aℓ alloy layer provided at the peripheral portion of the Aℓ-Si compound material. The above-described material is placed in the vacuum of 0.13 Pa (10⁻³ torr) or below at a temperature of 300 - 500°C to remove the occlusion gas included in the material. A cut material for a housing is cut out from the above-described material so as to have the above-described Aℓ alloy layer appear on the surface of the material. The above-described cut material for a housing is cut into a housing member.

The housing for a semiconductor device according to the present invention allows the occlusion gas contained in the Aℓ-Si compound material to be removed such that nitrogen gas in the occlusion gas is 0.01 percentage by weight or less, and therefore no gas is emitted in a thermal processing after the formation of the housing. Thermal distortion can be therefore prevented which is caused by the occlusion gas.

According to a manufacturing method of a housing for a semiconductor device in accordance with a further aspect of the present invention, the Aℓ-Si compound material is placed in the vacuum of 0.13 Pa (10⁻³ torr) or below at a temperature of 300 - 500°C to remove the occlusion gas contained in the above-described Aℓ-Si compound material, whereby no gas is emitted in the obtained housing even if the housing is subjected to a thermal processing thereafter. Thermal distortion produced at the time of heating caused by the occlusion gas can be therefore prevented.

According to the housing for a semiconductor device in accordance with a further aspect of the present invention, an aluminum alloy layer is formed on a surface of a cover attaching portion of the housing member. As a result, being welded through aluminum and aluminum, the welded portion between the housing member and the cover made of aluminum becomes hardened.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective view of a housing for a semiconductor device according to one embodiment of the present invention.

Fig. 2 is a sectional view taken along the line II-II of Fig. 1.

Fig. 3 is a diagram of a relation between density and thermal expansion coefficient of various metals.

Fig. 4 is a diagram showing a relation between density and thermal conductivity of various metals.

Fig. 5 is a diagram showing the manufacturing steps of the housing for a semiconductor device according to the present invention.

Fig. 6 is a diagram showing a relation between conditions and gas contents in a degassing process of an Aℓ-Si compound material.

Fig. 7 is a sectional view showing the correcting of curvature of a test piece by using a jig for correcting curvature.

Fig. 8 is a sectional view showing a process of measuring curvature of a test piece.

Fig. 9 is a sectional view showing a process of quantitatively measuring blister of a plated layer.

Figs. 10 to 13 are diagrams showing the manufacturing steps of a housing for a semiconductor device with an aluminum alloy layer provided on a surface of a cover attaching portion.

Fig. 14 is a sectional view of a housing for a semiconductor device comprising a housing member with an aluminum alloy layer provided on a surface of a cover attachment portion, and an aluminum cover attached by welding onto the housing member.

Fig. 15 is an enlarged view of the part A of Fig. 14.

Fig. 16 is a diagram showing another manufacturing step of the housing member with an aluminum layer provided on a surface of a cover attachment portion.

### DESCRIPTION OF THE PREFERRED EMBODIMENTS

The embodiments of the present invention will be described in the following with reference to the drawings.

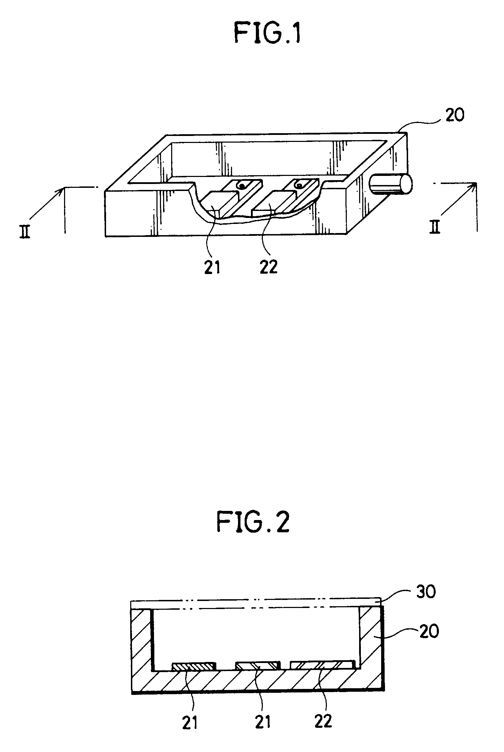

Fig. 1 is the perspective view of a housing for a semiconductor device according to one embodiment of the present invention. Fig. 2 is the sectional view taken along the line II-II of Fig. 1. Referring to these drawings, the housing for a semiconductor device comprises a housing member 20 having a space for housing a semiconductor device 21, a circuit board 22 and the like. A cover 30 is attached to the housing member 20. The housing member 20 is formed of an Aℓ-Si compound material (referred to as A-40 hereinafter) containing 60% by weight of Aℓ and 40% by weight of Si. In the A-40 used in the embodiment, the occlusion gas contained therein is removed such that at least the percentage by weight of the nitrogen gas is not larger than 0.01. Even if the heat is applied thereafter, the housing member 20 formed of the A-40 from which the occlusion gas is removed is not distorted due to the heat caused by the emission of the gas.

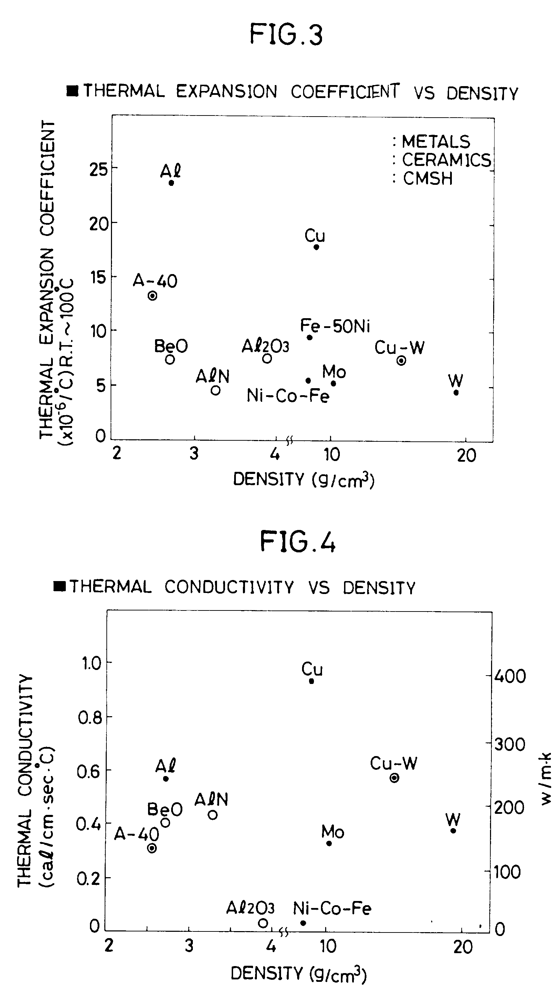

Referring to Fig. 3, the A-40 has the thermal expansion coefficient approximate to that of ceramics. Therefore, when a ceramic substrate with electronic parts mounted thereon is connected to the housing by soldering or the like, no warping at the connected portion nor crack in the ceramic substrate is produced at the time of the connection.

In addition, referring to Fig. 4, the A-40 has a small specific gravity and a relatively high thermal conductivity and therefore it is suitable for a housing material.

The manufacturing method of the housing member shown in Fig. 1 will be described.

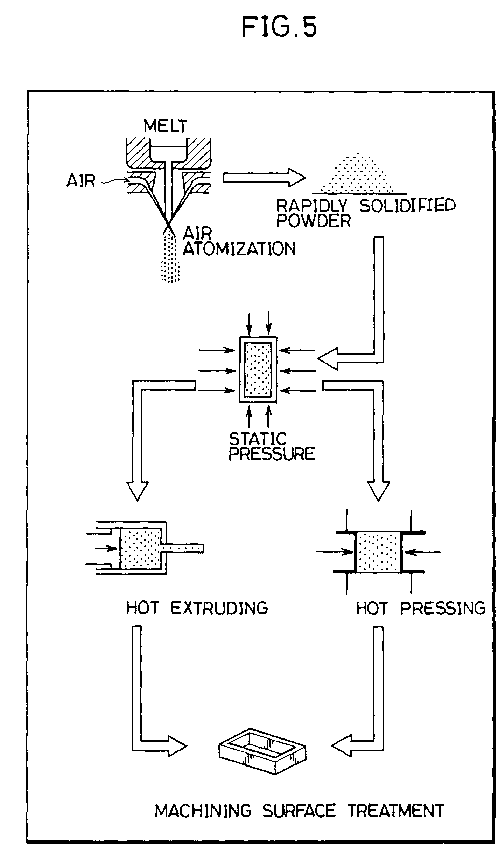

Referring to Fig. 5, rapidly solidified powder of Aℓ-Si alloy (containing 40% by weight of Si and 60% by weight of Aℓ) was prepared by an air atomization method. This rapidly solidified powder was molded by static pressure and then formed by hot working (hot extruding or hot pressing) into a material.

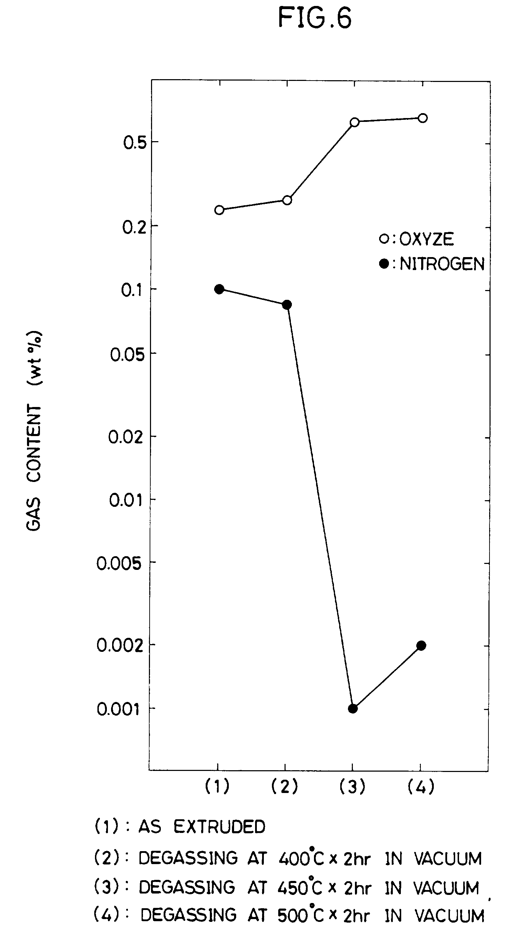

Then, although not shown, the obtained material was subjected to a heat treatment for two hours under the pressure of 0.13 Pa (10⁻³ torr) or below at a temperature of 450°C (which is referred to as a degassing hereinafter). Referring to Fig. 6, this degassing removed the occlusion gas from the inside of the material. The nitrogen gas contained in the material was found to be not larger than 0.001% by weight. Before the degassing, the material contained the nitrogen gas of not less than 0.1% by weight, oxygen gas of not less than 0.2% by weight, hydrogen gas and water vapor. While the contents of the gasses of hydrogen and water vapor could not be determined, it is considered that these gasses (hydrogen and vapor) are removed to a considerable extent under the above-described degassing condition that the content of the nitrogen gas is 0.01% by weight or less. No decrease of the oxygen gas was noted, which means oxygen combined with metal material (Aℓ, Si) to become oxide and the oxygen was analyzed. Therefore, the oxygen rarely exists as a gas in the material.

Subsequently, the material subjected to the degassing was cut to obtain the housing member from which the occlusion gas was removed.

### Example 1 and Comparative example 1

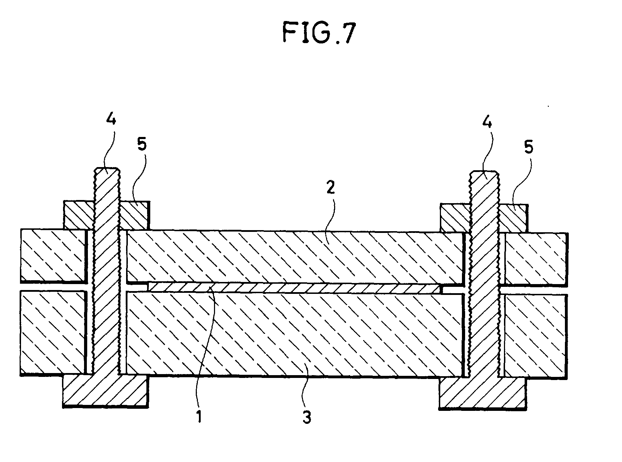

A test piece of 3mm x 10mm x 100mm was cut out of the above-described material subjected to the degassing and the test piece was subjected to a process for correcting warping thereof by using a jig for correcting warping as shown in Fig. 7. Referring to Fig. 7, the correction of the warping of the test piece 1 was carried out by interposing the test piece 1 between an upper steel surface plate 2 and a lower steel surface plate 3, fastening the opposite ends thereof with a steel bolt 4 and a steel nut 5 and heating the entire unit with the jigs attached thereto in a vacuum of 0.13 Pa (10⁻³ torr) or below at a temperature of 450°C for thirty minutes.

At the same time, as an example for comparison 1, the warping correcting process was performed under the same condition by using a test piece which was not subjected to the above-described degassing.

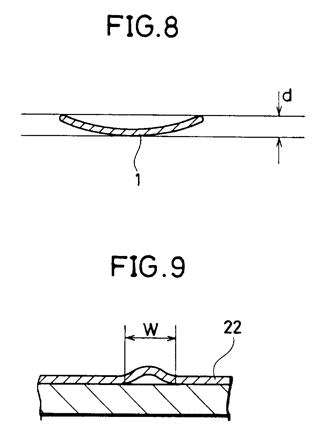

Referring to Fig. 8, the warping of the sample 1 could be obtained by measuring a difference d in height between the center portion and the end portion of the test piece 1.

The results thereof are shown in Table 1.

**Table 1**

| | Sample | 1 | 2 | 3 | 4 | 5 | average |
|---|---|---|---|---|---|---|---|
| Example 1 | before correcting warping | 55 | 60 | 45 | 60 | 50 | 54 |
| | after correcting warping | 23 | 25 | 30 | 15 | 20 | 23 |
| Comparative Example 1 | before correcting warping | 70 | 80 | 60 | 75 | 75 | 72 |
| | after correcting warping | 155 | 175 | 140 | 160 | 180 | 162 |

unit : µm / 100mm

Referring to Table 1, in the case of the Example 1, a difference in warping is small between the test piece before the correction of warping and the test piece after the same. This means that a warping correcting process is not required when a housing member is formed of a material of the Example 1, that is, the material subjected to a degassing.

On the contrary, in the case of the Example for comparison 1, it was found that the warping was increased after the correction of warping. This is because the occlusion gas in the material was emitted during the process for correcting warping, thereby distorting the test piece.

### Example 2 and Comparative example 2

Like the Example 1, the Aℓ-Si compound material was formed by hot working in accordance with Fig. 5. This Aℓ-Si compound material was subjected to the above-described degassing process. The test piece cut out from the Aℓ-Si compound material not subjected to a degassing (Example for Comparison 2) and the test piece cut out from the Aℓ-Si compound material subjected to the degassing (Example 2) were plated with nickel (0.3µm of zincate surface treatment and 2µm of electrolytic watt bath Ni), which were heated for 10 minutes in oxygen at a temperature of 350°C. Each blister of the surface plated layers of the obtained test pieces was examined. Ten samples were prepared for each and examined. Referring to Fig. 9, the blister of the plated layer was determined by measuring a width W of the blister of the plated layer 22. The results are shown in Table 2.

**Table 2**

| | |
|---|---|
| Example 2 | no blister of 5µm (the maximum width W) or more |
| Comparative Example 2 | many blister of 10 - 20µm (the maximum width W) or more were produced |

### Example 3

Like the Example 1, the Aℓ-Si compound material molded by hot working was prepared in accordance with Fig. 5. This Aℓ-Si compound material was subjected to the above-described degassing. Prepared were a test piece cut out from the Aℓ-Si compound material not subjected to a degassing and a test piece cut out from the Aℓ-Si compound material subjected to the degassing. The respective test piece surfaces were melted by heating using YAG laser to be solidified and the sections of the respective melted portions were compared with each other. As a result, it was found that while holes were produced in the test piece not subjected to a degassing, few holes were produced in the melted portion of the test piece subjected to the degassing. The laser was irradiated under the conditions that YAG was 20 pulse/second, a pulse width was 7 msec, Au dissolution content was 300 watt and a travelling speed was 500 mm/min.

### Example 4

The following example was directed to radically resolving the problem of the increase in size of the particles of the welded portion.

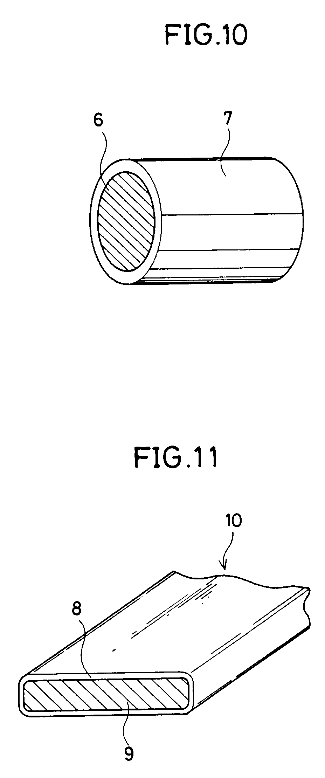

Referring to Fig. 10, the composite powder containing 60% by weight of Aℓ and 40% by weight of Si was molded by static pressure into a column shape having an outer diameter of 190mm and a height of 300mm and the molding was put in a sheath tube 7. The sheath tube 7 is an aluminum tube having an outer diameter of 200mm, a thickness of 5mm and a length of 300mm and an aluminum circular plate having an outer diameter of 200mm and a thickness of 5mm is welded to one end of the tube.

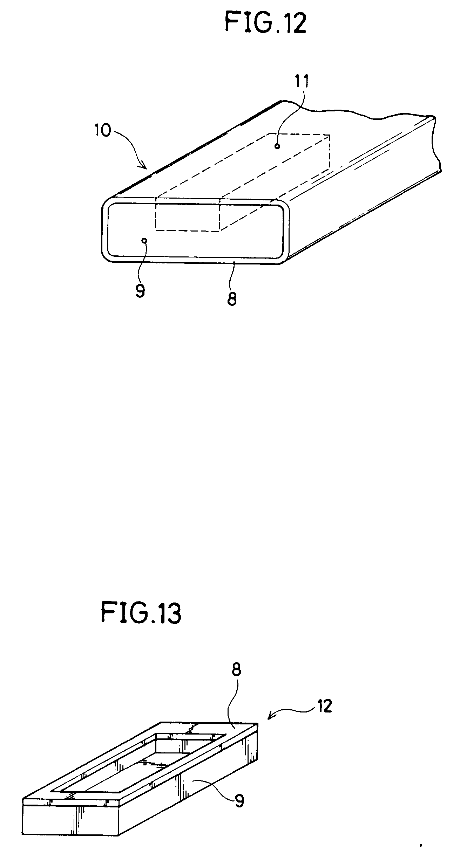

Referring to Fig. 11, the Aℓ-Si powder in the sheath tube was loaded in a container of an extruder and extruded by an extrusion die having an outer diameter of 100mm x 20mm to obtain a material 10 comprising an aluminum layer 8 around an Aℓ-Si compound material 9. Then, the obtained material was subjected to a thermal process for two hours under a pressure of 0.13 Pa (10⁻³ torr) or below at a temperature of 450°C. As a result, the occlusion gas was removed from the inside of the material. Referring to Fig. 12, a cut material for housing 11 was cut out from the material subjected to the degassing process such that the aluminum layer 8 appeared on the surface of the material.

Thereafter, referring to Fig. 13, a housing 12 having an opening at the center was manufactured by cutting process.

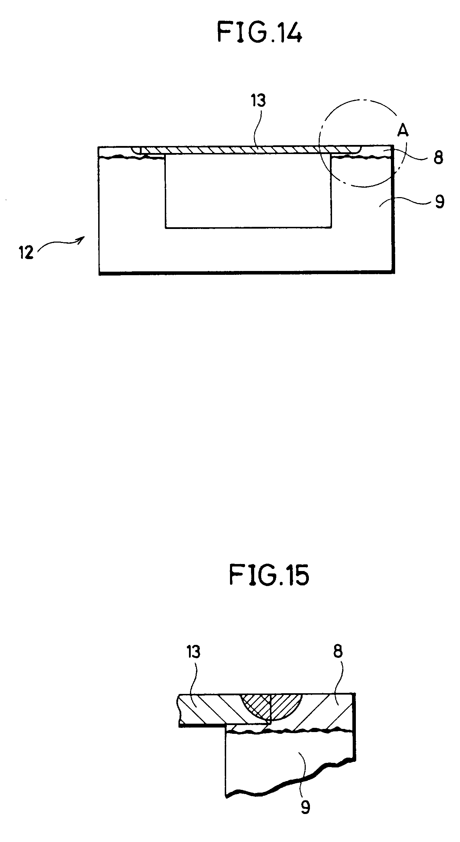

Referring to Fig. 14, an aluminum cover 13 of an aluminum alloy (Aℓ-4032) was welded to the obtained housing 12.

Fig. 15 is the enlarged view of the welded portion between the housing 12 and the aluminum cover 13. Referring to Fig. 15, the material and the aluminum cover could be connected with reliability because the aluminum cover 13 and the aluminum layer 8 were welded.

### Example 5

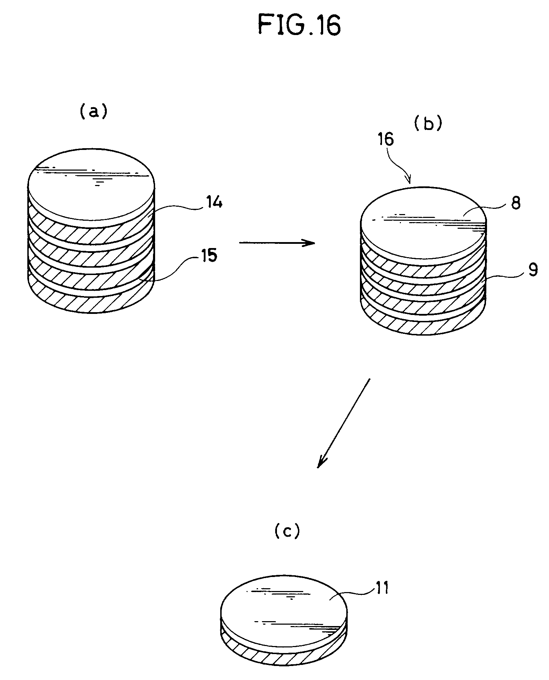

This is another example of a manufacturing method of a housing member with an aluminum alloy layer formed at a cover attachment portion. With reference to Fig. 16 (a), Aℓ-Si powder 14 and Aℓ powder 15 were stacked in layers and the stack was molded by static pressure. Referring to Fig. 16 (b), thereafter, the static molding was hot-pressed to obtain a material 16 in which the Aℓ-Si compound materials 9 and the Aℓ layers 8 were alternately stacked. Then, the material 16 was heated for two hours in the vacuum of 0.13 Pa (10⁻³ torr) or below at a temperature of 300 - 500°C to remove the occlusion gas contained in the material 16.

Thereafter, referring to Fig. 16 (c), the cut material for housing 11 was cut out so as to have the aluminum alloy layer 8 appear on the surface. Such a cut material for housing 11 can be also used for a housing producing the same effect as that by the example 4.

While in the above-described examples, described is an Aℓ-Si compound material containing 40% by weight of Si, the present invention is not limited thereto and that containing 30 - 45% by weight of Si can be preferably used.

As the foregoing, in the housing for a semiconductor device according to the present invention allows occlusion gas such as nitrogen gas, vapor gas or the like to be removed from the inside of the material of an Aℓ-Si compound material, so that no gas is emitted during a thermal treatment after the processing of the housing. Therefore, distortion due to cheat caused by the occlusion gas can be prevented at the time of heating. As a result, a reliable housing for a semiconductor device can be obtained.

In addition, when an aluminum layer is formed at a cover attachment portion of the housing for a semiconductor device, an aluminum cover can be welded to the housing with reliability.

## Claims

1. A housing for a semiconductor device, comprising:
a housing member formed of an Al-Si compound material and having space for enclosing said semiconductor device,
wherein the percentage of occluded nitrogen gas in said Al-Si compound material is 0.01 % by weight or less.

2. The housing according to claim 1, wherein said housing has a cover attachment portion for attaching a cover and an aluminum alloy layer is formed on the surface of said cover attachment portion.

3. The housing according to claim 2, wherein a film thickness of said aluminum alloy layer is 0.3 - 1mm.

4. The housing according to claim 2, wherein said Aℓ alloy layer is formed of pure Aℓ.

5. The housing according to claim 1, wherein the Si content of said Aℓ-Si compound material is 30 - 45 percentage by weight.

6. A method of manufacturing a housing for a semiconductor device, comprising the steps of:
preparing Aℓ-Si rapidly solidified powder,
molding said Aℓ-Si rapidly solidified powder by hot working to form an Aℓ-Si compound material,
placing said Aℓ-Si compound material under the conditions of a vacuum degree of 0.13 Pa (10⁻³ torr) or below and a temperature of 300 - 500°C, thereby removing the occlusion gas contained in said Aℓ-Si compound material, and
cutting said Aℓ-si compound material to form a housing member.

7. The method according to claim 6, wherein the Si content of said Aℓ-Si compound material is 30 - 45 percentage by weight.

8. A method of manufacturing a housing for a semiconductor device, comprising the steps of:
preparing Aℓ-Si rapidly solidified powder,
molding said Aℓ-Si rapidly solidified powder by static pressure and then putting the obtained molding into a sheath tube made of an Aℓ alloy,
molding said sheath tube and said Aℓ-Si compound molding as an unit by extrusion, thereby forming a material having an Aℓ alloy layer provided around the Aℓ-Si compound material,
placing said material under the conditions of a vacuum degree of 0.13 Pa (10⁻³ torr) or below and a temperature of 300 - 500°C, thereby removing the occlusion gas contained in said material,
cutting a cut material for a housing so as to have said Aℓ alloy layer appear on the surface thereof.
cutting said cut material for a housing into a housing member.

9. The method according to claim 8, wherein the Si content of said Aℓ-Si rapidly solidified powder is 30 - 45 percentage by weight.

10. A method of manufacturing a housing for semiconductor device, comprising the steps of:
preparing Aℓ-Si rapidly solidified powder,
preparing Aℓ alloy powder,
alternately stacking said Aℓ-Si double rapidly solidified powder and said Aℓ alloy powder and molding the obtained stack by hot working, thereby forming a material with Aℓ-Si compound materials and Aℓ alloy layers stacked alternately,
placing said material under the conditions of a vacuum degree of 0.13 Pa (10⁻³ torr) or below and a temperature of 300 - 500°C, thereby removing the occlusion gas contained in said material,
cutting a cut material for a housing from said material so as to have said Aℓ alloy layer appear on the surface thereof, and
cutting said cut material for housing into a housing member.

11. The method according to claim 10, wherein the Si content of said Aℓ-Si rapidly solidified powder is 30 - 45 percentage by weight.

## Patentansprüche

1. Gehäuse für eine Halbleitervorrichtung, umfassend:
ein Gehäusebauteil, das aus einem Al-Si Verbindungsmaterial gebildet ist und Platz für das Umschließen der Halbleitervorrichtung hat,
worin der Anteil an eingeschlossenem Stickstoffgas in dem Al-Si-Verbindungsmaterial 0,01 Gew.% oder weniger ist.

2. Gehäuse nach Anspruch 1, worin das Gehäuse einen Abdeckbefestigungsabschnitt zum Befestigen einer Abdeckung hat, und eine Aluminiumlegierungsschicht auf der Oberfläche des Abdeckbefestigungsabschnittes gebildet ist.

3. Gehäuse nach Anspruch 2, worin eine Filmdicke der Aluminiumlegierungsschicht 0.3 - 1 mm ist.

4. Gehäuse nach Anspruch 2, worin die Aluminiumlegierungsschicht aus reinem Aluminium gebildet ist.

5. Gehäuse nach Anspruch 1, worin der Si-Anteil in dem Al-Si Verbindungsmaterial 30 - 45 Gew.% ist.

6. Verfahren zur Herstellung eines Gehäuses für eine Halbleitervorrichtung, das folgende Schritte umfaßt:
Herstellen von schnell verfestigendem Al-Si-Pulver, Formen des schnell verfestigenden Al-Si-Pulvers durch Warmverformung, um ein Al-Si-Verbindungsmaterial zu formen,
Stellen des Al-Si-Verbindungsmaterials unter die Bedingungen eines Vakuums von 0.13 Pa (10⁻³ torr) oder weniger und einer Temperatur von 300 - 500°C, wodurch das eingeschlossene Gas beseitigt wird, das in dem Al-Si-Verbindungsmaterial enthalten ist, und
Zuschneiden des Al-Si-Verbindungsmaterials, um ein Gehäusebauteil zu bilden.

7. Verfahren nach Anspruch 6, worin der Si-Anteil des Al-Si-Verbindungsmaterials 30 - 45 Gew.-% ist.

8. Verfahren zur Herstellung eines Gehäuses für eine Halbleitervorrichtung, das folgende Schritte umfaßt:
Herstellung von schnell verfestigendem Al-Si-Pulver, Formen des schnell verfestigenden Al-Si-Pulvers durch statischen Druck und dann Einlegen des erhaltenen Formteils in ein Umhüllungsrohr, welches aus einer Al-Legierung hergestellt ist,
Formen des Umhüllungsrohres und des Al-Si-Verbindungsformteiles als eine Einheit durch Strangpressen, wodurch ein Material gebildet wird, welches eine Al-Legierungsschicht aufweist, welche um das Al-Si-Verbindungsmaterial vorhanden ist,
Stellen des Materials unter die Bedingungen eines Vakuums von 0.13 Pa (10⁻³ torr) oder darunter und einer Temperatur von 300 - 500°C, wodurch das eingeschlossene Gas entfert wird, welches in dem Material enthalten ist,
Zuschneiden eines Schnittmaterials für ein Gehäuse, so daß die Al-Legierungsschicht auf der Oberfläche davon erscheint,
Zuschneiden des Schnittmaterials für ein Gehäuse in ein Gehäusebauteil.

9. Verfahren nach Anspruch 8, worin der Si-Anteil des schnellverfestigenden Al-Si-Pulvers 30 - 45 Gew.-% ist.

10. Verfahren zur Herstellung eines Gehäuses für eine Halbleitervorrichtung, das folgende Schritte umfaßt:
Herstellen des schnell verfestigenden Al-Si-Pulvers,
Herstellen des Al-Legierungspulvers,
wiederholtes Aufeinanderschichten des schnell verfestigenden Al-Si-Pulvers und des Al-Legierungspulvers und Formen des so erhaltenen Stapels durch Warmverformung, wodurch ein Material mit Al-Si-Verbindungsmaterialien und Al-Legierungsschichten gebildet wird, die abwechselnd geschichtet sind,
stellen des Materials unter die Bedingungen eines Vakuums von 0.013 Pa (10⁻³ torr) oder darunter und einer Temperatur von 300 - 500°C, wodurch das eingeschlossene Gas entfert wird, welches in dem Material enthalten ist,
Zuschneiden des Schnittmaterials für ein Gehäuse aus dem Material, sodaß die Al-Legierungsschicht auf der Oberfläche davon erscheint, und
Zuschneiden des Schnittmaterials für ein Gehäuse in ein Gehäusebauteil.

11. Verfahren nach Anspruch 10, worin der Si-Gehalt des schnellverfestigenden Al-Si-Pulvers 30 - 45 Gew.-% ist.

## Revendications

1. Boîtier pour dispositif à semi-conducteurs, comprenant :
un élément de boîtier formé par un matériau composé Aℓ-si et ayant un espace pour recevoir le dispositif à semiconducteurs,
dans lequel le pourcentage de gaz d'azote occlus dans le matériau composé Aℓ-Si est de 0,01 % en poids ou moins.

2. Boîtier selon la revendication 1, dans lequel le boîtier présente une portion de fixation de couvercle destinée à fixer un couvercle et une couche d'alliage aluminium est formée à la surface de la portion de fixation de couvercle.

3. Boîtier selon la revendication 2, dans lequel l'épaisseur de la pellicule de la couche d'alliage en aluminium est de 0,3 - 1 mm.

4. Boîtier selon la revendication 2, dans lequel la couche d'alliage Aℓ est constituée par de l'Aℓ pur.

5. Boîtier selon la revendication 1, dans lequel la teneur en Si du matériau composé Aℓ-Si est de 30 - 45 % en poids.

6. Procédé pour la fabrication d'un boîtier pour dispositif à semi-conducteurs, comprenant les étapes consistant à :
préparer de la poudre rapidement solidifiée Aℓ-Si,
mouler la poudre rapidement solidifiée Aℓ-Si par façonnage à chaud pour former le matériau composé Aℓ-Si,
placer le matériau composé Aℓ-Si dans les conditions de degré sous vide de 0,13 Pa (10⁻³ torr) ou au-dessous et à une température de 300 - 500°C, permettant ainsi d'enlever le gaz occlus dans le matériau composé Aℓ-Si, et
découper le matériau composé Aℓ-Si pour former un élément de boîtier.

7. Procédé selon la revendication 6, dans lequel la teneur en Si du matériau composé Aℓ-Si est de 30 - 45 % en poids.

8. Procédé pour la fabrication d'un boîtier pour dispositif à semi-conducteurs, comprenant les étapes consistant à :
préparer la poudre rapidement solidifiée Aℓ-Si,
mouler la poudre rapidement solidifiée Aℓ-Si par pression statique puis en plaçant le moulage obtenu dans une gaine protectrice réalisée en alliage Aℓ,
mouler la gaine protectrice et le moulage composé Aℓ-Si en une seule unité par extrusion, permettant ainsi de former un matériau ayant une couche d'alliage Aℓ disposée autour du matériau composé Aℓ-Si,
placer le matériau dans les conditions d'un degré de vide de 0,13 Pa (10⁻³ torr) ou au-dessous et une température de 300 - 500°C, permettant ainsi d'enlever le gaz occlus dans le matériau,
- découper un matériau pour le boîtier de façon à ce que cette couche d'alliage Aℓ apparaisse à sa surface, et
découper ce matériau pour boîtier à la forme d'un élément de boîtier.

9. Procédé selon la revendication 8, dans lequel la teneur en Si de la poudre rapidement solidifiée Aℓ-Si est de 30 - 45 % en poids.

10. Procédé pour la fabrication d'un boîtier pour dispositif à semi-conducteurs, comprenant les étapes consistant à :
préparer de la poudre rapidement solidifiée Aℓ-Si,
préparer une poudre d'alliage Aℓ,
empiler alternativement la poudre rapidement solidifiée double Aℓ-Si et la poudre d'alliage Aℓ et mouler l'empilage obtenu par façonnage à chaud, permettant ainsi de former un matériau avec des couches de composé Aℓ-Si et des couches d'alliage Aℓ empilées alternativement,
placer le matériau dans les conditions de vide de 0,13 Pa (10⁻³ torr) ou au-dessous et à une température de 300 - 500°C, permettant ainsi d'enlever le gaz occlus dans le matériau,
- découper un matériau pour le boîtier à partir de ce matériau de façon à avoir une couche d'alliage Aℓ à sa surface, et
découper le matériau pour boîtier en un élément de boîtier.

11. Procédé selon la revendication 10, dans lequel la teneur en Si de la poudre rapidement solidifiée Aℓ-Si est de 30 - 45 % en poids.
